# EUROPÄISCHE PATENTSCHRIFT

(11) **EP 1 509 642 B1**
(45) Veröffentlichungstag und Bekanntmachung des Hinweises auf die Patenterteilung: **18.07.2007**
(21) Anmeldenummer: 03724889.5
(22) Anmeldetag: 06.05.2003
(51) Int. Cl.: C30B 15/08, C30B 15/00

(54) **ANORDNUNG ZUR HERSTELLUNG VON KRISTALLSTÄBEN MIT DEFINIERTEM QUERSCHNITT UND KOLUMNARER POLYKRISTALLINER STRUKTUR MITTELS TIEGELFREIER KONTINUIERLICHER KRISTALLISATION**
DEVICE FOR THE PRODUCTION OF CRYSTAL RODS HAVING A DEFINED CROSS-SECTION AND COLUMN-SHAPED POLYCRYSTALLINE STRUCTURE BY MEANS OF FLOATING-ZONE CONTINUOUS CRYSTALLIZATION
DISPOSITIF POUR LA PRODUCTION DE BARREAUX CRISTALLINS PRESENTANT UNE SECTION TRANSVERSALE DEFINIE ET UNE STRUCTURE POLYCRISTALLINE COLONNAIRE AU MOYEN D'UNE CRISTALLISATION CONTINUE REALISEE EN DEHORS DU CREUSET

(30) Priorität: 06.05.2002 DE 10220964
(43) Veröffentlichungstag der Anmeldung: 02.03.2005
(73) Patentinhaber: PV SILICON FORSCHUNGS- UND PRODUKTIONS AG, 99099 Erfurt (DE)
(72) Erfinder: Abrosimov, Nikolai V., 12681 Berlin (DE); Riemann, Helge, 15732 Schulzendorf (DE)
(74) Vertreter: Hoffmann, Heinz-Dietrich
(86) Internationale Anmeldenummer: PCT/DE2003/001515
(87) Internationale Veröffentlichungsnummer: WO 2003/093540

(56) Entgegenhaltungen:
- DE-A- 19 538 020
- DE-A- 19 610 650
- US-A- 3 393 054
- US-A- 4 565 600
- US-A- 4 834 832

## Beschreibung

Die Erfindung betrifft eine Anordnung zur Herstellung von Kristallstäben mit definiertem Querschnitt und kolumnarer polykristalliner Struktur mittels tiegelfreier kontinuierlicher Kristallisation (CCC = crucible-fed continuous cystallisation), mindestens aufweisend einen mit Kristallmaterial gefüllten Tiegel mit einer zentralen Ableitung zum Transport des Tiegelinhalts auf einen unter dem Tiegel angeordneten wachsenden Kristallstab, wobei die zentrale Ableitung in den Schmelzmeniskus auf der oberen Stirnfläche des Kristallstabes eintaucht, Mittel zum stetig regelbaren Beschicken des Tiegels mit festem Kristallmaterial und Mittel zur gleichzeitigen Zufuhr der Schmelzenergie und der Einstellung der Kristallisationsfront.

Dem Stand der Technik nach wird die Kristallisation von polykristallinem Block-Silizium aus Si-Granulat in einer zeitlichen Aufeinanderfolge des Schmelzen des Rohstoffes und der späteren Kristallisation der Schmelze oder mittels gleichzeitigem Schmelzen und Kristallisieren bei unmittelbarer thermischer Wechselwirkung realisiert.

So ist in 11th E.C. PHOTOVOLTAIC SOLAR ENERGY CONFERENCE, 12-16 October 1992, MONTREUX, Switzerland, pp. 1070-1073 eine Lösung beschrieben, mit der die Herstellung von polykristallinem Block-Silizium mittels elektromagnetischen Stranggießens (EMC - Electromagnetic Casting) durchgeführt wird. Hierbei wird die Schmelze von einer rohrförmigen runden oder quadratischen Induktionsspule umschlossen (Prinzip des kalten Tiegels), die für das Aufschmelzen der zugeführten Siliciumstücke und zugleich für die Kristallisation des Kristallstabes, der nach unten kontinuierlich herausgezogen wird, sorgt. Das Hochfrequenzfeld der Induktionsspule bewirkt elektrodynamische Kräfte, die die Schmelze von der Tiegelwand fernhalten und den Querschnitt des Block-Siliziums formen. Kennzeichnend für diese Anordnung ist die den Siliziumkristallstab umschließende Heizung und die Stützung der Schmelze durch magnetische Kräfte.

Durch den lateralen Wärmeeintrag ist bei dieser Anordnung die Phasengrenze jedoch stark parabolisch durchgebogen, was zu extremen thermomechanischen Spannungen im polykristallinen Stab führt. Auch ist die Mehrzahl der Kristallite nicht axial (kolumnar) ausgerichtet, was den Wirkungsgrad von Solarzellen aus diesem Material verschlechtert. Dieser Effekt nimmt mit zunehmender Ziehgeschwindigkeit und für größere Stabquerschnitte zu. Die Ziehgeschwindigkeit ist daher für technisch relevante Querschnitte auf 0,8 bis 1,2 mm/min beschränkt.

Bei dem in DE 195 38 020 A1 beschriebenen FZ-Verfahren wird die Schmelze mittels einer Widerstandsheizung erwärmt und der notwendige Leistungseintrag in die Kristallisationsfront mittels einer Induktionsheizspule, die vorzugsweise als tellerförmige Flachspule mit zentralem Innenloch ausgebildet ist, realisiert. Diese technisch aufwendige Heizanordnung aus zwei getrennten Heizmitteln dient sowohl dem kontrollierten Nachchargieren von Si-Granulat als auch der Verhinderung einer Unterkühlung des Kristallstabes bei der Herstellung von stabförmigen Si-Einkristallen mit großen Durchmessern.

In den Proceedings der 16th European Photovoltaic Solar Energy Conference, 1-5 May 2000, Glasgow, UK, pp. 1616-1619 ist eine Anordnung für die Herstellung von Kristallstäben mittels ITCC (inductiv top-heated continuous crystallisation) beschrieben. Diese Anordnung weist einen Trichter auf, dem Si-Granulat zugeführt wird, dessen Rohr dicht über der Oberfläche der Schmelze auf dem oberen Ende des Kristallstabes endet. Dem Trichter wird über eine Förderleitung festes Rohmaterial zugeführt, das mittels einer Heizlampe vorgewärmt wurde. Dieses Material fällt durch den Trichter, der von einem flachen ringförmigen Induktor umschlossen ist, auf die Schmelze auf den Si-Kristallstab, wo die induktive Heizung das Schmelzen des dort schwimmenden Materials bewirkt. 1 bis 2 cm unter der Flüssig-Fest-Phasengrenze kristallisiert unter Rotation um seine Achse der zylindrische polykristalline Si-Stab aus. Zwar ermöglicht diese Anordnung eine weniger gekrümmte Phasengrenze und entsprechend kolumnar ausgerichtete Kristallite bei einer Wachstumsgeschwindigkeit von höchstens 1 bis 1,5 mm/min, da die Heizenergie zum Aufschmelzen einer großen Menge von Rohmaterial zugleich die Unterkühlung der Schmelze und damit die Kristallisationsrate senkt. Mit dieser Lösung sind jedoch praktisch nur kreisrunde Querschnitte der Kristallstäbe realisierbar.

Im Statusreport 1996 Photovoltaik, vorgelegt vom Projektträger Biologie, Energie, Ökologie des Bundesministeriums für Bildung, Wissenschaft, Forschung und Technologie - Forschungszentrum Jülich GmbH - anläßlich des Statusseminars Photovoltaik 1996 in Bad Breisig vom 23. bis 25. April 1996, 5 - 1 bis 5 - 11 wird ebenfalls über die tiegelfreie kontinuierliche Kristallisation von Silicium berichtet. So ist zum Einen eine Anordnung zur tiegelfreien kontinuierlichen Kristallisation von Siliciumstäben mit rundem Querschnitt mit Flächen-Lampenheizung gezeigt. Hierbei wird die Heizenergie der Lampen auf die obere Stirnfläche des Si-Stabes gestrahlt, weitere Lampen sind an der Peripherie angeordnet und dienen der Heizung der Schmelze und der Nachheizung des Stabes nach der Rekristallisation. Oberhalb des Si-Stabes ist ein Rahmen aus nichtschmelzendem Material angeordnet, der teilweise in die Schmelze eintaucht und als formgebendes Element wirkt. Damit sind dann auch Kristallstäbe mit quadratischem Querschnitt herstellbar. Problematisch ist hierbei die Einstellung einer definierten Heizleistung, da bei zu hoher Heizleistung die Höhe der freien Schmelze, die sich zwischen Si-Stab und dem Rahmen befindet, anwächst und flüssiges Silicium auslaufen kann. Bei zu geringer Heizleistung kann der Si-Stab am Rahmen festwachsen. Um die Nachteile der Zuführung von kaltem Granulat zu beseitigen, wurde oberhalb des Rahmens eine flache Wanne aus Graphit angeordnet, aus der über eine zentrale Bohrung die für eine flüssige Nachchargierung vorgesehene Schmelze in den formgebenden Rahmen abfließt. Wie erkennbar, bereitet bei dieser Anordnung die Einstellung einer definierten/optimalen Heizleistung Schwierigkeiten, was hier mit aufwendigen Mitteln, nämlich mit fokussierter Lampenstrahlung und zusätzlichem Reflektor, realisiert wurde. Wie bereits oben erwähnt, wurden also zwei optische Heizungen eingesetzt, wovon eine für das Aufschmelzen des Rohmaterials eingesetzt ist und die andere zur Steuerung der Kristallisation des herzustellenden Si-Stabes.

Eine weitere Möglichkeit für die tiegelfreie kontinuierliche Kristallisation von Silicium wird in der oben erwähnten Veröffentlichung beschrieben und bezieht sich auf eine Float-Zone-Kristallziehanlage. Oberhalb einer Induktionsspule befindet sich in einem Rezipienten ein Vorratsbunker, der das Si-Granulat für die Nachchargierung aufnimmt. Das Granulat wird über einen Quarztrichter durch Öffnungen des Induktors auf die Oberfläche des Si-Stabes geführt, wo es fast vollständig aufgeschmolzen wurde. Einige Si-Körner gelangten jedoch zum Stabrand und bildeten dort Kristallisationskeime. Um ein vollständiges Aufschmelzen des Granulats zu erreichen, wurde dieses über ein durch den Induktor ragendes und die Schmelze auf dem Si-Stab berührendes Quarzrohr zugeführt. Zwar wird hierbei schon eine gute kolumnare Kornstruktur erreicht, jedoch erfolgt bei dieser Anordnung sowohl das Aufschmelzen des Materials als auch die Kristallisation unterhalb des Rahmens. Die eingesetzte Heizanordnung liefert eine Leistungsverteilung, die sowohl für die Aufschmelzrate als auch für die Kristallisationsgeschwindigkeit begrenzend wirkt. Ein formgebender Rahmen kam bei der zweitgenannten Anordnung nicht zum Einsatz.

Aufgabe der Erfindung ist es, eine Anordnung zur Herstellung von Kristallstäben mit definiertem Querschnitt und kolumnarer polykristalliner Struktur anzugeben, die bei Einsatz technisch weniger aufwendiger Heizmittel als im Vergleich zum Stand der Technik hohe Kristallisationsraten bei stabiler Phasengrenze gestattet und gleichzeitig eine bessere Anpassbarkeit der Heizleistung an die konkrete Anwendung ermöglicht.

Die Aufgabe wird durch eine Anordnung der eingangs beschriebenen Art dadurch gelöst, dass erfindungsgemäß dicht über dem wachsenden Kristallstab ein die Schmelze berührender Rahmen angeordnet ist, das Mittel zur gleichzeitigen Zufuhr der Schmelzenergie und der Einstellung der Kristallisationsfront auf dem wachsenden Kristallstab eine flache Induktionsspule mit einer Öffnung ist, wobei die Induktionsspule in ihrem Abstand zum Tiegel und zur Kristallisationsfront vertikal beweglich angeordnet und derart ausgebildet ist, dass oberhalb der Induktionsspule im Tiegel das Rohmaterial geschmolzen wird und unterhalb der Induktionsspule das durch die zentrale rohrförmige Ableitung, die durch die Öffnung der Induktionsspule auf die Oberfläche des Si-Kristallstabes geführt ist, transportierte geschmolzene Material kristallisiert und ein dem gewünschten Querschnitt des Kristallstabes angepasstes Temperatufeld erzeugt wird.

Bei der erfindungsgemäßen Anordnung wird bereits im Tiegel die Schmelze erzeugt, die über die zentrale zylinderförmige Ableitung durch die Öffnung in der Induktionsspule direkt nach unten auf den Kristallstab geführt wird und damit das Schmelzen des Materials vom Kristallisieren des Stabes thermisch weitgehend entkoppelt und auch mehr Gestaltungsfreiheit für den Induktor erlaubt. Dieser gewährleistet das Vorhandensein eines geschlossenen Schmelzmeniskus und eines Temperaturfeldes, das dem nicht rotierenden Stab in Kombination mit dem den Meniskus berührenden Führungsrahmen dem wachsenden Stab einen definierten - vorzugsweise einen quadratischen - Querschnitt aufgeprägt. Durch eine Längsbewegung des Kristallstabes nach unten bildet sich wenige mm unter dem Rahmen die Wachstumsphasengrenze, und entsprechend dem im wesentlichen axialen Wärmestrom ist die Ausrichtung der Kristallite überwiegend kolumnar. Der zwischen Tiegel und Kristall angeordnete Heizinduktor ist vom Fachmann den Parametern für den zu ziehenden Kristallstab (Formung des Temperaturfeldes für den gewünschten Querschnitt des Stabes, effektive Leistungsübertragung) anzupassen.

Die erfindungsgemäße Anordnung ermöglicht durch Variation des Abstandes der Induktionsspule vom Schmelztiegel und von der Kristallisationsfront die thermische Entkopplung des Schmelzprozesses des Granulats vom Kristallisationsprozess der Schmelze, damit werden höhere Kristallisationsraten bei stabiler Phasengrenze für den kontinuierlich wachsenden polykristallinen Stab erreicht. Somit kann über den Abstand auch während des Herstellungsprozesses die Aufteilung der Gesamtleistung in Schmelz- und Kristallisationsleistung und damit die Lage der Phasengrenze eingestellt werden.

In einer Ausführungsform ist vorgesehen, dass der Führungsrahmen aus einem widerstandsfähigen Material gebildet ist und eine definierte geometrische Form aufweist.

In einer weiteren Ausführungsform ist oberhalb des Tiegels eine zusätzliche Strahlungseizung für das schnellere Schmelzen des Rohmaterials angeordnet, damit kann die Wärmezufuhr des Tiegels unabhängig von der des Kristallstabes eingestellt werden. Dies kann beispielsweise notwendig sein, um bei Arbeiten in Schutzgas die benötigte Wärmemenge zur Verfügung zu stellen.

In einer anderen bevorzugten Ausführungsform ist die Wandung des Tiegelbodens an der Verbindung zur zylinderförmigen Ableitung erhöht ausgebildet. Dies soll das vollständige Leerlaufen des Tiegels und damit seine Zerstörung verhindern.

Strahlungsschutzschilde sind zur Isolation und zur Gewährleistung ebener Phasengrenzen in Höhe der Kristallisationsfront um den Kristallstab angeordnet.

Die flache Induktionsspule ist in einer weiteren Ausführungsform so ausgebildet, dass die Phasengrenze den Führungsrahmen nicht berührt. Die Spule weist eine quadratische oder rechteckige Form auf.

Die Erfindung wird in folgendem Ausführungsbeispiel anhand von Zeichnungen näher erläutert.
Dabei zeigen
Fig. 1 schematisch eine erfindungsgemäße Anordnung im Längsschnitt;
Fig. 2 schematisch die Draufsicht auf Fig. 1 mit einem Induktor zur Herstellung eines Krsitallstabes mit quadratischem Querschnitt.

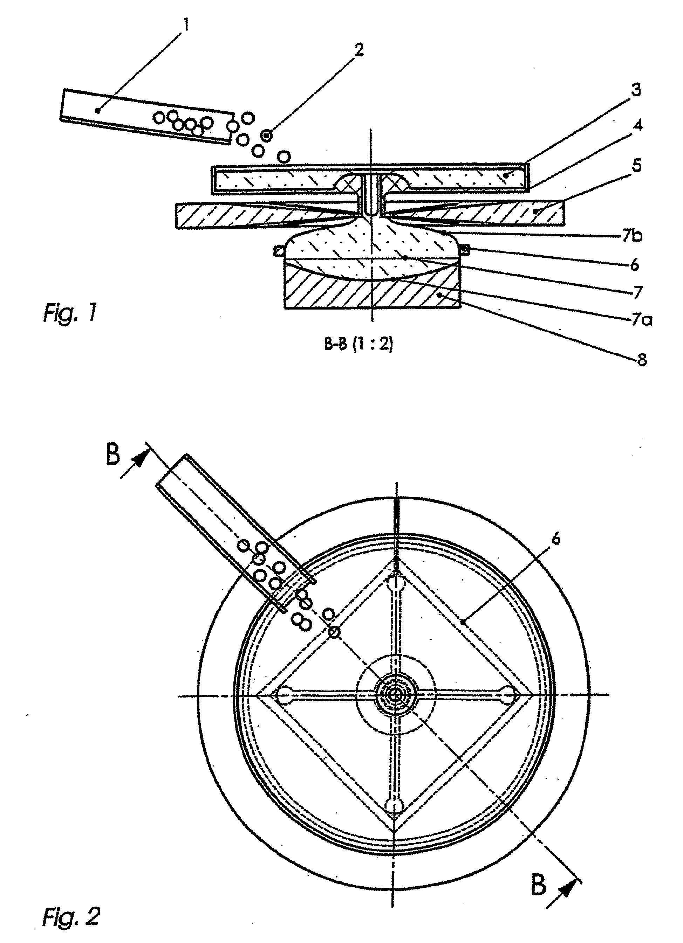

In Fig. 1 ist eine erfindungsgemäße Anordnung im Längsschnitt dargestellt, bei der aus einem Förderer **1** in einen Tiegel **4** festes Rohmaterial **2** (z.B. Si-Granulat) gelangt. Der Schmelztiegel **4** weist einen zentralen Ablauf nach unten auf. Unterhalb des Schmelztiegels **4** und über dem Kristallstab **8** ist der flache Induktor **5** für die HF-Heizung angeordnet. Der Führungsrahmen **6** steht in Kontakt mit dem Schmelzmeniskus **7b** und gibt diesem die Form vor. Die Energiezufuhr wird mittels der HF-Heizung nun so eingestellt, dass sowohl das in den Tiegel 4 gelangende Rohmaterial **2** dort geschmolzen wird (Schmelze **3)** als auch das auf den Kristallstab **8** geführte geschmolzene Material beim langsamen Hinunterziehen des Stabes **8** kristallisiert. Eingezeichnet sind ebenfalls die 3-Phasenlinie **7** und die Kristallisationsphasengrenze **7a.** Zur Einstellung eines ausbalancierten Verhältnisses zwischen der Leistung zum Aufschmelzen des Rohmaterials **2** und der Leistung für die Kristallisation ist der Schmelztiegel **4** in seinem Abstand zum flachen Induktor **5** veränderlich angeordnet.

Die schematische Draufsicht auf die in Fig. 1 dargestellte erfindungsgemäße Anordnung zeigt in Fig. 2 einen definiert geformten Induktor 5, hier mit quadratischer Symmetrie, zur Herstellung eines Kristallstabes mit quadratischem Querschnitt.

## Patentansprüche

1. Anordnung zur Herstellung von Kristallstäben mit definiertem Querschnitt und kolumnarer polykristalliner Struktur mittels tiegelfreier kontinuierlicher Kristallisation, mindestens aufweisend einen mit Kristallmaterial gefüllten Tiegel mit einer zentralen Ableitung zum Transport des Tiegelinhalts auf einen unter dem Tiegel angeordneten wachsenden höhenverstellbaren Kristallstab, wobei die zentrale Ableitung in den Schmelzmeniskus auf der oberen Stirnfläche des Kristallstabes eintaucht, Mittel zum stetig regelbaren Beschicken des Tiegels mit festem Kristallmaterial sowie Mittel zur Zufuhr der Schmelzenergie und Mittel zur Einstellung der Kristallisationsfront auf dem wachsenden Kristallstab,
**dadurch gekennzeichnet, dass**
als gemeinsames Mittel zur gleichzeitigen Zufuhr der Schmelzenergie und zur Einstellung der Kristallisationsfront auf dem wachsenden Kristallstab (8) eine flache Induktionsspule (5) mit einer Öffnung angeordnet ist, wobei der Abstand zwischen Induktionsspule (5) und Tiegel (4) und der Abstand zwischen Induktionsspule (5) und Kristallisationsfront einstellbar und derart eingestellt ist, dass oberhalb der Induktionsspule (5) im Tiegel (4) das Kristallmaterial geschmolzen wird (3) und unterhalb der Induktionsspule (5) das durch die zentrale rohrförmige Ableitung, die durch die Öffnung der Induktionsspule (5) auf die Oberfläche des wachsenden Kristallstabes (8) geführt ist, transportierte geschmolzene Material kristallisiert und ein dem gewünschten Querschnitt des Kristallstabes (8) angepasstes Temperatufeld erzeugt wird, und
dicht über dem wachsenden Kristallstab (8) ein die Schmelze berührender Rahmen (6) angeordnet ist.

2. Anordnung nach Anspruch 1,
**dadurch gekennzeichnet, dass**
der Führungsrahmen (6) aus einem widerstandsfähigen Material gebildet ist und eine definierte geometrische Form aufweist.

3. Anordnung nach Anspruch 1,
**dadurch gekennzeichnet, dass**
eine zusätzliche optische Heizung für das Schmelzen des Rohmaterials im Tiegel (4) oberhalb des Induktors (5) angeordnet ist.

4. Anordnung nach Anpruch 1,
**dadurch gekennzeichnet, dass**
der Boden des Tiegels (4) an der Verbindung zur zylinderförmigen Ableitung erhöht ausgebildet ist.

5. Anordnung nach Anpruch 1,
**dadurch gekennzeichnet, dass**
Strahlungsschutzschilde in Höhe der Kristallisationsfront um den Kristallstab (8) angeordnet sind.

6. Anordnung nach Anpruch 1,
**dadurch gekennzeichnet, dass**
die Induktionsspule (5) eine quadratische Form aufweist.

7. Anordnung nach Anpruch 1,
**dadurch gekennzeichnet, dass**
die Induktionsspule (5) eine rechteckige Form aufweist.

## Claims

1. Arrangement for producing crystal rods having a defined cross-section and column-shaped polycrystalline structure by means of floating-zone continuous crystallisation, at least comprising a crucible filled with crystal material having a central drain outlet for transporting the contents of the crucible to a growing adjustable-height crystal rod located underneath the crucible, wherein the central drain outlet dips into the melt meniscus on the upper front face of the crystal rod, means for continuously adjustable charging of the crucible with solid crystal material as well as means for supplying the melting energy and means for adjusting the crystallisation front on the growing crystal rod, **characterised in that** a flat induction coil (5) with an opening is arranged on the growing crystal rod (8) as a common means for simultaneously supplying the melting energy and for adjusting the crystallisation front, wherein the distance between the induction coil (5) and the crucible (4) and the distance between the induction coil (5) and the crystallisation front is adjustable and is adjusted in such a manner that the crystal material is molten (3) above the induction coil (5) in the crucible (4) and below the induction coil (5) the molten material transported through the central tubular drain outlet which is guided through the opening of the induction coil (5) onto the surface of the growing crystal rod (8), crystallises and a temperature field adapted to the desired cross-section of the crystal rod (8) is produced and a frame (6) in contact with the melt is arranged close above the growing crystal rod (8).

2. The arrangement according to claim 1, **characterised in that** the guide frame (6) is formed from a resistant material and has a defined geometric shape.

3. The arrangement according to claim 1, **characterised in that** an additional optical heater for fusing the raw material in the crucible (4) is arranged above the inductor (5).

4. The arrangement according to claim 1, **characterised in that** the bottom of the crucible (4) is configured as raised at the connection to the cylindrical drain outlet.

5. The arrangement according to claim 1, **characterised in that** radiation protective shields are arranged around the crystal rod (8) at the height of the crystallisation front.

6. The arrangement according to claim 1, **characterised in that** the induction coil (5) has a square shape.

7. The arrangement according to claim 1, **characterised in that** the induction coil (5) has a rectangular shape.

## Revendications

1. Dispositif pour la fabrication de barreaux de cristal avec une section transversale définie et une structure colonnaire polycristalline au moyen de la cristallisation continue sans creuset, présentant au moins un creuset rempli de matériau cristallin avec une évacuation centrale pour le transport duc contenu de creuset à une barreau de cristal réglable en hauteur croissant disposé sous le creuset, l'évacuation centrale plongeant dans le ménisque de fusion sur la surface frontale supérieure du barreau de cristal, des moyens pour le chargement réglable en continu du creuset avec du matériau solide cristallin ainsi que des moyens pour l'amenée de l'énergie de fusion et des moyens pour le réglage du front de cristallisation sur le barreau de cristal croissant,
**caractérisé en ce qu'**
en tant que moyen commun pour l'amenée simultanée de l'énergie de fusion et pour le réglage du front de cristallisation sur le barreau de cristal croissant (8), une bobine d'indiction plate (5) est disposée avec une ouverture, la distance entre la bobine d'induction (5) et le creuset (4) et la distance entre la bobine d'induction (5) et le front de cristallisation sont réglables et sont réglées de sorte qu'au-dessus de la bobine d'induction (5), le matériau cristallin est fondu (3) dans le creuset (4) et en dessous de la bobine d'induction (5), le matériau fondu transporté par l'évacuation centrale tubulaire, qui traverse l'ouverture de la bobine d'induction (5), est guidé à la surface du barreau de cristal croissant (8) et est cristallisé et un champ de température adapté à la section transversale souhaitée du barreau de cristal (8) est généré et **en ce que** juste au-dessus du barreau de cristal croissant (8) est disposé un cadre (6) touchant le bain de fusion.

2. Dispositif selon la revendication 1,
**caractérisé en ce que**
le cadre de guidage (6) est réalisé dans un matériau résistant et présente une forme géométrique définie.

3. Dispositif selon la revendication 1,
**caractérisé en ce qu'**
un chauffage optique supplémentaire est disposé au dessus de l'inducteur (5) pour la fusion du matériau brute dans le creuset (4).

4. Dispositif selon la revendication 1,
**caractérisé en ce que**
le fond du creuset (4) est réalisé surélevé par rapport à la connexion avec l'évacuation cylindrique.

5. Dispositif selon la revendication 1,
**caractérisé en ce que**
des écrans protecteurs contre les radiations sont disposés à hauteur du front de cristallisation autour du barreau de cristal (8).

6. Dispositif selon la revendication 1,
**caractérisé en ce que**
la bobine d'induction (5) présente une forme carrée

7. Dispositif selon la revendication 1,
**caractérisé en ce que**
la bobine d'induction (5) présente une forme rectangulaire.
